# EUROPEAN PATENT SPECIFICATION

(11) **EP 2 062 854 B1**
(45) Date of publication and mention of the grant of the patent: **28.12.2011**
(21) Application number: 07791951.2
(22) Date of filing: 03.08.2007
(51) Int. Cl.: C01B 33/02, B02C 19/18

(54) **SILICON SUPPORTING DEVICE AND SILICON HEATING RAPIDLY COOLING APPARATUS UTILIZING THE SAME**
SILICIUMTRAGVORRICHTUNG UND VORRICHTUNG ZUM ERHITZEN UND SCHNELLEN ABKÜHLEN VON SILICIUM DAMIT
DISPOSITIF SUPPORTANT DU SILICIUM ET APPAREIL DE REFROIDISSEMENT RAPIDE DU SILICIUM CHAUFFÉ UTILISANT CE DISPOSITIF

(43) Date of publication of application: 27.05.2009
(73) Proprietor: Teoss CO., LTD., Tokyo 185-0012 (JP)
(72) Inventor: MURAI, Tsuyoshi, Kokubunji-shi Tokyo 185-0012 (JP); KONAKA, Toshinori, Kokubunji-shi Tokyo 185-0012 (JP)
(74) Representative: Horn Kleimann Waitzhofer
(86) International application number: PCT/JP2007/065278
(87) International publication number: WO 2009/019749

(56) References cited:
- JP-A- 2005 103 529
- JP-A- 2005 288 332
- US-A- 4 871 117

## Description

### Background of the Invention

### field of the Invention

The present invention relates to an silicon supporting apparatus and silicon heating and quenching equipment, which are for use in crushing silicon as a raw material of silicon wafers used as a semiconductor material. The silicon supporting apparatus is heated in a heating apparatus while supporting the material silicon, taken out of the heating apparatus, and then quenched while supporting the material silicon.

### Description of the Related Art

Silicon wafers used as a semiconductor material are produced by cutting a single-crystal silicon rod having a substantially cylindrical shape along its diameter into slices having a predetermined thickness. Such a single-crystal silicon rod is produced by dipping a single-crystal silicon piece as a seed crystal in a material silicon melt and then slowly pulling up the seed crystal to grow single-crystal silicon. As the material silicon, the remaining part of another single-crystal silicon rod, from which a predetermined number of silicon wafers have been cut, or polycrystalline silicon produced by the Siemens method or the monosilane method is used.

The material silicon is melted by placing it in a quartz crucible and heating it. In order to melt the material silicon efficiently, the material silicon needs to be crushed into pieces having sizes suitable to be placed in a crucible.

Conventionally, the material silicon has been crushed manually using tungsten-made hammers or the like. However, manual crushing of very hard material silicon is a hard work, and in addition, tungsten as a material of the hammers or the like is adhered to the surface of the material silicon during crushing and therefore the purity of the material silicon is reduced.

In order to solve such a problem, there has been developed equipment for heating and quenching silicon for use in heating material silicon to high temperatures and then quenching it to produce crack (see Patent Document 1:Japanese Patent Application Laid-open No. 2005-288332). The equipment for heating and quenching silicon disclosed in Patent Document 1 includes a heating furnace for heating material silicon and a water tank with water for submerging the material silicon and the silicon supporting apparatus for cooling. The heating furnace has a furnace main body in which the material silicon is to be placed, and the furnace main body can be opened and closed to put and take the material silicon in and out of it. In the furnace main body, there are provided a heater and a silicon-supporting apparatus for supporting material silicon in the furnace main body. The silicon-supporting apparatus has a plurality of pipes for supporting material silicon, and the surface of the pipes is coated with titanium.

The material silicon is heated in the heating furnace of the equipment for heating and quenching silicon disclosed in Patent Document 1, and then the furnace main body of the heating furnace is opened to push the silicon-supporting apparatus supporting the material silicon out of the heating furnace, and then the material silicon is put into the water tank. When the heated material silicon is put into the water tank, the material silicon is quenched with water reserved in the water tank so that cracks are produced in the material silicon. The material silicon having cracks is very brittle, and is therefore easily crushed into pieces only by applying slight pressure. Therefore, by using the equipment for heating and quenching silicon disclosed in Patent Document 1, it is possible to minimize efforts to crush material silicon into pieces.

Further, since the pipes for supporting material silicon are coated with titanium, there is no fear that the purity of the material silicon will be reduced as long as the material silicon is in contact with the titanium coating. Usually, chemically-stable titanium oxide having a high hardness is formed on the surface of titanium, but even when the titanium oxide comes into contact with the material silicon, it is not likely that titanium will be adhered to the surface of the material silicon. In the event that the titanium oxide is adhered to the material silicon, it can be easily removed by chemically etching the material silicon.

However, even when the silicon-supporting apparatus disclosed in Patent Document 1 is used, the reduction in the purity of the material silicon cannot be completely solved. More specifically, there is a fear that in the process of coating the pipes of the silicon-supporting apparatus disclosed in Patent Document 1 with titanium, pinholes are generated in the titanium coating. Further, the pipes of the silicon-supporting apparatus disclosed in Patent Document 1 are not only heated in an atmosphere of about 1000°C in the heating furnace but also cooled when pushed out of the heating furnace, and therefore there is a fear that the titanium coating will be peeled off from the surface of the pipes due to the difference in thermal elongation between the pipe and the titanium coating caused by alternate heating and cooling of the pipes.

If pinholes are generated in the titanium coating or the titanium coating is peeled off from the surface of the pipes, the material silicon comes into direct contact with the pipes and therefore stainless steel as a material of the pipes is adhered to the surface of the material silicon, thereby causing a problem that the purity of the material silicon is reduced.

Further, if pinholes are generated in the titanium coating or the titanium coating is peeled off from the surface of the pipes, the pipes need to be recoated with titanium. In order to recoat the pipes with titanium, it is necessary to detach the silicon-supporting apparatus from the furnace main body and then send it to a factory or the like where coating with titanium can be carried out. This causes a problem that the process of crushing material silicon has to be stopped for a long period of time, thereby making it difficult to perform maintenance of the silicon-supporting apparatus.

### SUMMARY OF THE INVENTION

The present invention has been made to solve the above problems associated with the prior art. It is therefore a main object of the present invention to provide an easy-maintenance apparatus for supporting silicon which can support material silicon without reducing its purity and equipment for heating and quenching silicon using such an apparatus for supporting silicon.

In accordance with an aspect of the present invention, an apparatus 14 is provided as set forth in claim 1 for supporting material silicon 12 while it is heated and quenched, the apparatus 14 including: a silicon-supporting part 22 for supporting the material silicon 12, which has a plurality of pipes 32 arranged to be spaced apart from each other at predetermined intervals and each having an internal flow path 34 for flowing a cooling medium L; at least one contact-preventing member 24 made of titanium and provided to be contacted with an outer surface of the pipe 32 to prevent the contact between the material silicon 12 and the pipe 32; and a fixing member 26 made of titanium and fixing the contact-preventing member 24 to the pipe 32.

In the silicon supporting apparatus 14 according to the present invention, the titanium-made contact-preventing member 24 is provided between the material silicon 12 and the pipes 32 to prevent the contact between the material silicon 12 and the pipes 32. The contact-preventing member 24 is fixed to the pipe 32 by means of the fixing member 26. This eliminates the necessity to coat the pipes 32 with titanium, and therefore there is no fear that the generation of pinholes resulting from the process of coating with titanium. Further, the difference in thermal elongation between the pipe 32 and the contact-preventing member 24 and fixing member 26 caused by alternate heating and cooling of the silicon supporting apparatus 14 is mainly absorbed by the expansion and contraction of the fixing member 26, and therefore there is no fear that the contact-preventing member 24 will be fallen off the pipe 32.

Further, when an abrasion of the contact-preventing member 24 or the fixing member 26 occurs, the silicon supporting apparatus 14 can be repaired by replacing only the damaged contact-preventing member 24 or fixing member 26, and it is not necessary to send the silicon supporting apparatus 14 to a factory or the like for repair.

Further, chemically-stable titanium oxide having a high hardness is usually formed on the surface of titanium, but if titanium is heated to about 380°C or higher, titanium oxide is formed not only on the surface but also inside the contact-preventing member 24 and the fixing member 26 so that the contact-preventing member 24 and the fixing member 26 become brittle. However, in the silicon supporting apparatus 14 according to the present invention, the pipes 32 and the contact-preventing member 24 and the fixing member 26 which are provided so as to be in contact with the outer surface of the pipes 32 are cooled by the cooling medium L flowing in the internal flow paths 34 of the pipes 32, and therefore even when the silicon supporting apparatus 14 is heated together with the material silicon 12 in a heating apparatus 16 at about 1000°C, the temperatures of the contact-preventing member 24 and the fixing member 26 are not undesirably increased, thereby making it possible to avoid the contact-preventing member 24 and the fixing member 26 from becoming brittle.

Further, since the silicon-supporting part 22 for supporting the material silicon 12 is constituted from a plurality of the pipes 32, the silicon-supporting part 22 can be altered to suit the size or shape of the material silicon 12 by changing the number of the pipes 32 or the spacing between the adjacent pipes 32.

The contact-preventing member 24 may be formed by longitudinally dividing a titanium-made pipe into two or more, the fixing member 26 has a strip shape, and the contact-preventing member 24 is fixed to the pipe 32 by winding the fixing member 26 around the contact-preventing member 24 and the pipe 32.

Since the contact-preventing member 24 formed by longitudinally dividing a titanium-made pipe into two or more is fixed to the pipe 32 by winding the fixing member 26 around the contact-preventing member 24 and the pipe 32, it is possible to easily attach and detach the contact-preventing member 24 to and from the pipe 32. This makes it possible to provide an easy-maintenance silicon supporting apparatus 14.

The contact-preventing member 24 may be laid on a plurality of the pipes 32, and has a water through hole 60.

Since the contact-preventing member 24 is laid on a plurality of the pipes 32, it is possible to more easily detach the contact-preventing member 24 attached to the silicon-supporting part 22 as compared to a case where the contact-preventing member 24 is attached to each of the pipes 32. This makes it possible to provide an easy-maintenance silicon supporting apparatus 14.

Further, when the silicon supporting apparatus 14 while supporting the material silicon 12 is submerged in water contained in a water tank 18 to quench the material silicon 12 and then the material silicon 12 is taken out of the water, the water can pass through the water through hole 60 provided in the contact-preventing member 24, and therefore the silicon supporting apparatus 14 is easily submerged in water contained in the water tank 18 and is well drained when taken out of the water.

In accordance with a second aspect of the present invention, the apparatus 14 further includes a contacting part 28 provided at the end of the silicon-supporting part 22 so that the material silicon 12 may contact against it, and the contacting part 28 has a main body 35 and a titanium-made contact-preventing member 36 for the contacting part provided between the material silicon 12 and the main body 35 to prevent from contacting between the material silicon 12 and the main body 35.

In the silicon supporting apparatus 14 according to the present invention, since the contacting part 28, against which the material silicon 12 may contact, is provided at the end of the silicon-supporting part 22, in the event that the material silicon 12 moves on the silicon-supporting part 22 in the axial direction of the pipe 32, the material silicon 12 contacts with the contacting part 28 at the end of the pipe 32 and therefore cannot move beyond the contacting part 28, thereby making it possible to prevent the material silicon 12 from falling off the silicon supporting apparatus 14.

Further, since the titanium-made contact-preventing member 36 for the contacting part is provided between the material silicon 12 and the main body 35 to prevent the contact between the material silicon 12 and the main body 35, there is no fear that the purity of the material silicon 12 will be reduced due to the adhesion of foreign substances to the surface of the material silicon 12.

In accordance with the third aspect of the present invention, silicon heating and quenching equipment includes: the silicon supporting apparatus 14; a heating apparatus 16 for heating the material silicon 12 and the silicon supporting apparatus 14; and a water tank 18 with water for submerging the material silicon 12 and the silicon supporting apparatus 14 for quenching.

According to the present invention, since there is no fear that the generation of pinholes and the falling off of the contact-preventing member from the pipe, foreign substances will NOT be adhered to the surface of material silicon. It is possible to provide an easy-maintenance apparatus for supporting silicon which can support material silicon without reducing its purity and equipment for heating and quenching silicon using such the apparatus for supporting silicon.

### BRIEF DESCRIPTION OF THE DRAWINGS

[Fig. 1]

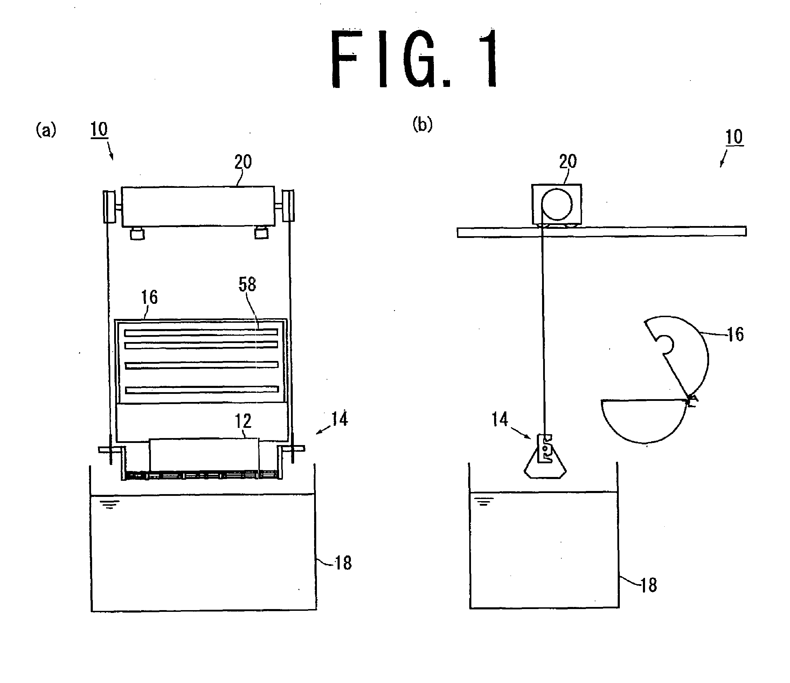

   Fig. 1(a) is a front view of equipment for heating and quenching silicon according to the present invention, and Fig. 1(b) is a right side view of the same.
[Fig. 2]

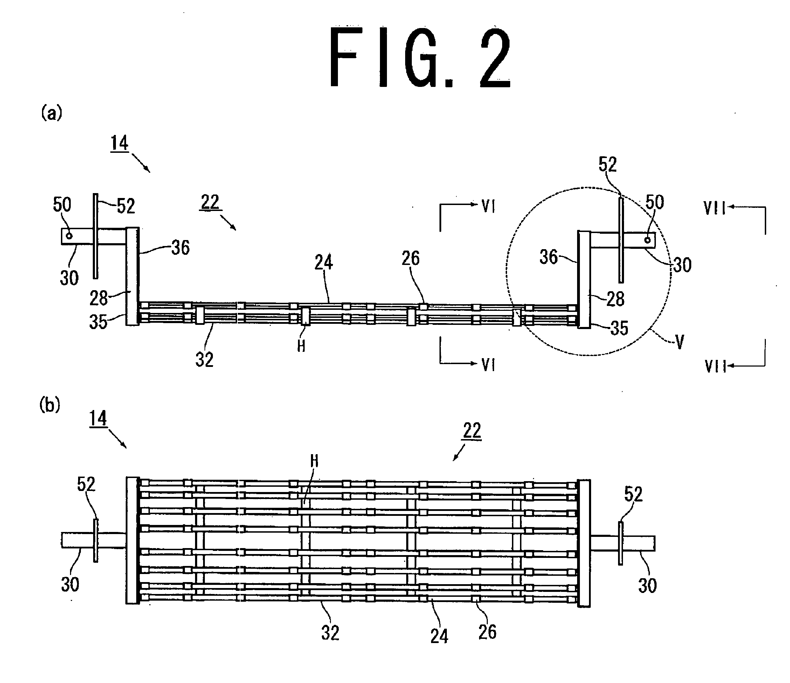

   Fig. 2(a) is a front view of a silicon supporting apparatus according to the first embodiment of the present invention, and Fig. 2(b) is a plan view of the same.
[Fig. 3]

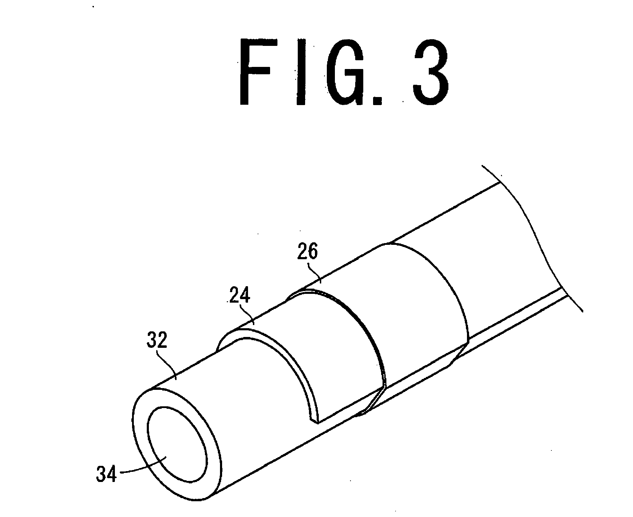

   Fig. 3 is a perspective view showing a state where a contact-preventing member is fixed to a pipe by means of a fixing member.
[Fig. 4]

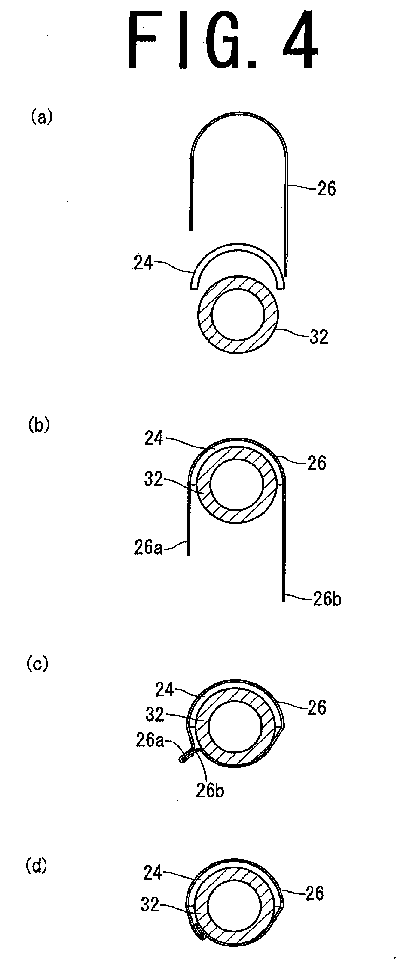

   Figs. 4(a) to 4(d) are diagrams showing a method for fixing the contact-preventing member to a pipe by means of the fixing member.
[Fig. 5]

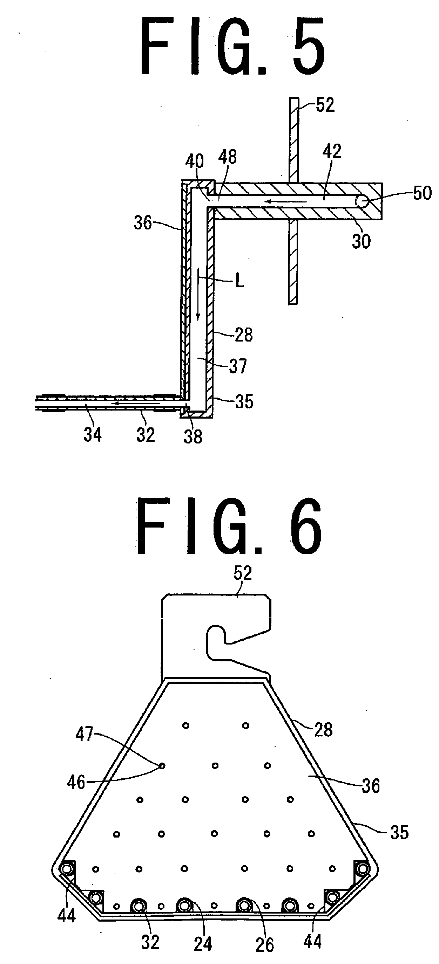

   Fig. 5 is an enlarged sectional view of a portion represented by "V" in Fig. 2(a).
[Fig. 6]
   Fig. 6 is a sectional view taken along the VI-VI line in Fig. 2(a) and seen in a direction indicated by the arrows.
[Fig. 7]

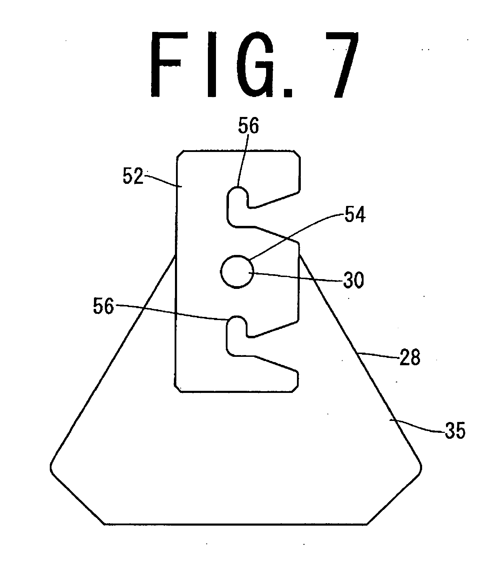

   Fig. 7 is a sectional view taken along the VII-VII line in Fig. 2 (a) and seen in a direction indicated by the arrows.
[Fig. 8]

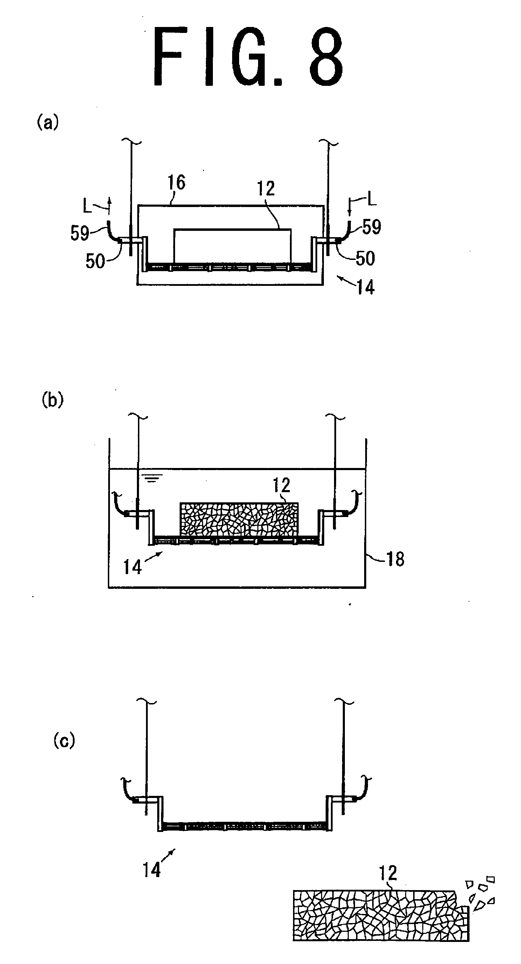

   Figs. 8(a) to 8(c) are diagrams showing a method for heating and cooling material silicon.
[Fig. 9]

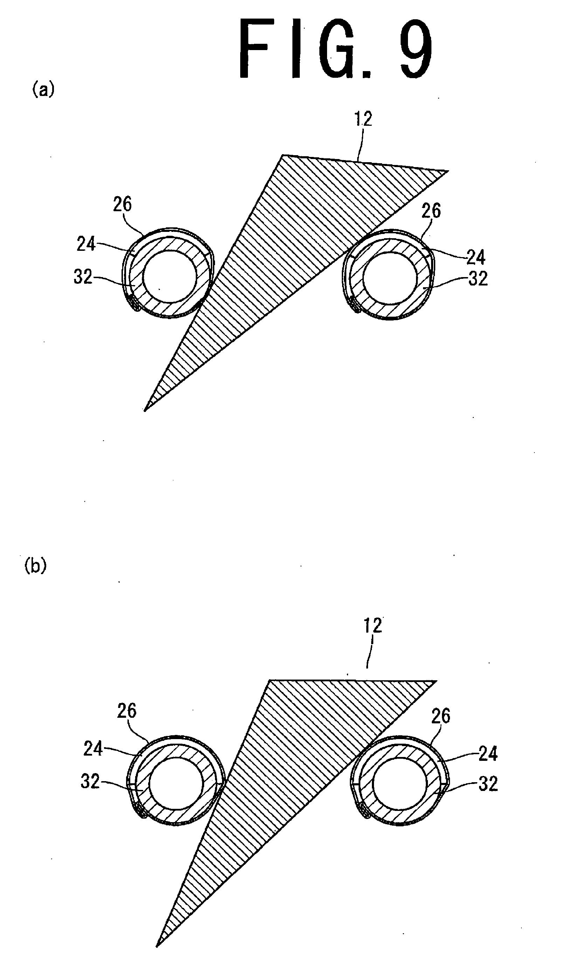

   Fig. 9(a) is a diagram for illustrating a modification of the fixing member, and Fig. 9 (b) is a diagram for illustrating the fixing member according to the first embodiment of the present invention.
[Fig. 10]

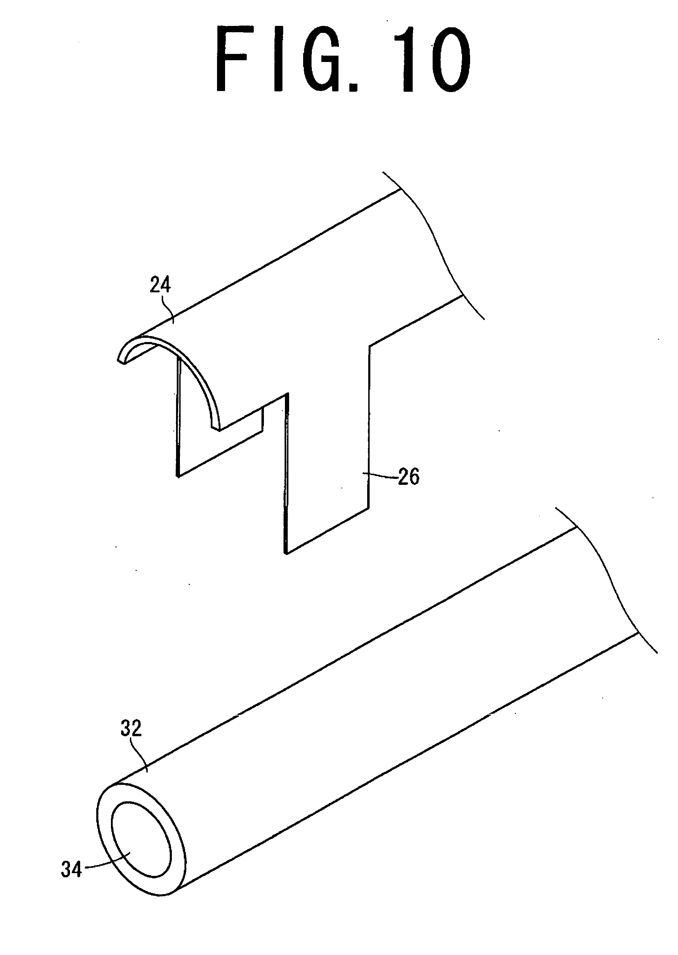

   Fig. 10 is a diagram for illustrating a modification of the fixing member.
[Fig. 11]

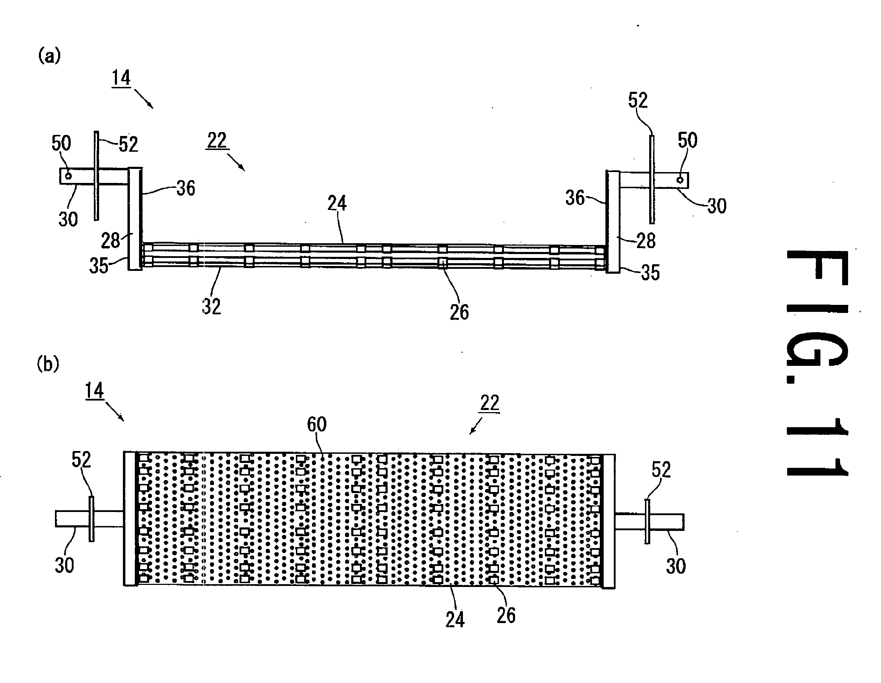

   Fig. 11 (a) is a front view of an apparatus for supporting silicon according to a second embodiment of the present invention, and Fig. 11(b) is a plan view of the same.
[Fig. 12]

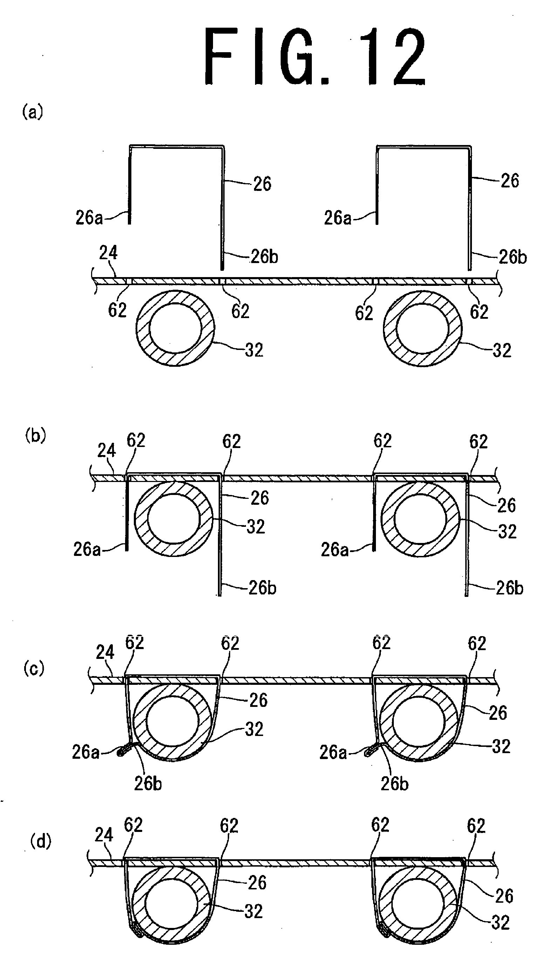

   Figs. 12 (a) to 12 (d) are sectional views showing a method for fixing a contact-preventing member according to the second embodiment of the present invention to a pipe by means of a fixing member.

### DETAILED DESCRIPTION OF THE PREFERRED EMBODIMENT

### (First Embodiment)

The equipment 10 for heating and quenching silicon according to a first embodiment of the present invention is used to heat material silicon 12 to high temperatures and then quench the material silicon 12 by submersion into water to produce cracks in the material silicon 12. As shown in Fig. 1, the equipment 10 for heating and quenching silicon includes the silicon supporting apparatus 14 , a heating apparatus 16, a water tank 18, and a crane 20 for hoisting the silicon supporting apparatus 14.

The silicon supporting apparatus 14 is used to support the material silicon 12, and is heated in the heating apparatus 16 while supporting the material silicon 12, taken out of the heating apparatus 16 after heating, and then submerged into water reserved in the water tank 18 together with the material silicon 12. As shown in Fig. 2, the silicon supporting apparatus 14 includes a silicon-supporting part 22, a contact-preventing member 24, a fixing member 26, a contacting part 28, and an axial part 30.

The silicon-supporting part 22 is for supporting the material silicon 12, and is constituted of a plurality of pipes 32 which are arranged to be spaced apart from each other in parallel.

The pipe 32 is made of stainless steel. As shown in Fig. 3, inside the pipe 32, there is provided an internal flow path 34 for flowing a cooling medium L to cool the pipe 32. The flow path for flowing the cooling medium L will be described later.

As shown in Fig. 2, the silicon-supporting part 22 according to the first embodiment of the present invention has a predetermined number of spacers H (in this embodiment, four spacers) provided so as to be orthogonal to the axial direction of the pipe 32 to keep a predetermined spacing between the adjacent pipes 32. The spacers H are welded to the bottom of the pipes 32.

The contact-preventing member 24 is a member for preventing contact directly between the material silicon 12 placed on the silicon-supporting part 22 and the pipe 32. The contact-preventing member 24 is formed by longitudinally dividing a high-purity titanium pipe into halves (i.e., by cutting a high-purity titanium pipe in the axial direction thereof along a surface passing through the center thereof). The inner diameter of the contact-preventing member 24 is substantially the same as the outer diameter of the pipe 32 so that the inner surface of the contact-preventing member 24 and the outer surface of the pipe 32 are brought into surface contact with each other. Further, the length of the contact-preventing member 24 is substantially the same as the entire length of the pipe 32, and therefore one contact-preventing member 24 is fixed to one pipe 32. The thickness of the contact-preventing member 24 according to the first embodiment of the present invention is 0.5 mm. The length of the contact-preventing member 24 may be shorter than that of the pipe 32 to facilitate conveyance and handling. In this case, the pipe 32 is covered with a plurality of the contact-preventing members 24 continuously placed along the entire length of the pipe 32 with no space between them.

The fixing member 26 is a strip-shaped member made of high-purity titanium and for fixing the contact-preventing member 24 to the pipe 32. The length of the fixing member 26 is slightly larger than the outer circumferential length of the pipe 32. A plurality of the fixing members 26 are arranged to be spaced at predetermined intervals to fix one contact-preventing member 24 to one pipe 32.

Hereinbelow, a method for fixing a contact-preventing member 24 according to the first embodiment of the present invention will be described in detail with reference to Fig. 4. First, a pipe 32, a contact-preventing member 24, and a fixing member 26 are prepared (see Fig. 4(a)), and then the contact-preventing member 24 is attached to the outer surface of the pipe 32 at a position against which material silicon 12 is to contact, and the fixing member 26 is attached to the outer surface of the contact-preventing member 24 (see Fig. 4 (b)). Then, the fixing member 26 is wrapped around the contact-preventing member 24 and the pipe 32 to fix the contact-preventing member 24 to the pipe 32. At this time, since the fixing member 2b has a length slightly larger than the outer circumferential length of the pipe 32, one end 26a of the fixing member 26 and the other end 26b of the fixing member 26 overlap each other. One end 26a of the fixing member 26 is folded back and the other end 26b of the fixing member 26 is inserted between the folds (see Fig. 4(c)). Then, the both ends 26a and 26b of the fixing member 26 are together folded toward the outer surface of the pipe 32. In this way, the contact-preventing member 24 is fixed to the pipe 32 by means of the fixing member 26 (see Fig. 4(d)).

As shown in Fig. 2, the contacting part 28 is provided at the end of the silicon-supporting part 22 so that the material silicon 12 may contact to it. The contacting part 28 has a main body 35 and a contact-preventing member 36 for the contacting part. According to the first embodiment of the present invention, a pair of the contacting parts 28 is provided at both ends of the silicon-supporting part 22 so as to be opposed to each other.

The main body 35 is a substantially triangular-shaped plate extending in a direction orthogonal to the axial direction of the pipe 32. As shown in Fig. 5, inside the main body 35, there is provided an internal flow path 37 for flowing the cooling medium L. Further, the internal flow path 37 is connected to the internal flow path 34 of the pipe 32 through a pipe connecting hole 38 provided in the lower end portion of the main body 35, and also connected to an internal flow path 42 (which will be described later) of the axial part 30 through an axial part connecting hole 40 provided in the upper end portion of the main body 35. That is, the pipe 32 is connected to the lower end portion of the main body 35, and the axial part 30 is connected to the upper end portion of the main body 35.

The contact-preventing member 36 for the contacting part is a plate made of titanium and provided between the material silicon 12 and the main body 35 to prevent the contact between the material silicon 12 and the main body 35. As shown in Fig. 2, the contact-preventing member 36 for the contacting part is attached to each of the surfaces, facing each other, of the two main bodies 35. Hereinafter, one surface of the main body 35, to which the contact-preventing member 36 for the contacting part is attached, will be referred to as an "inner surface" of the main body 35, and the other surface of the main body 35, to which the axial part 30 is attached, will be referred to as an "outer surface" of the main body 35.

As shown in Fig. 6, the contact-preventing member 36 for the contacting part has a shape substantially the same as that of the inner surface of the main body 35, and has notches 44 provided at positions corresponding to positions where the pipes 32 are connected to the inner surface of the main body 35 so as not to interfere with the pipes 32. Further, the contact-preventing member 36 for the contacting part has holes 46 provided at positions corresponding to screw holes (not shown) provided in the inner surface of the main body 35, and is attached to the main body 35 so as to come in close contact with the inner surface of the main body 35 by means of titanium screws 47 engaged with the screw holes through the holes 46.

The axial part 30 is a column attached to the outer surface of the main body 35 constituting the contacting part 28. As shown in Fig. 5, inside the axial part 30, there is provided an internal flow path 42. The axial part 30 has a contacting part contacting hole 48 provided so as to penetrate one end surface thereof (i.e., the left end surface of the axial part 30 in Fig. 5) to provide communication between the internal flow path 42 and the internal flow path 37 of the main body 35, and also has a hole 50 for charging or discharging a cooling medium provided at the other end thereof so as to penetrate the outer surface thereof and connected to the internal flowpath 42. The axial part 30 is connected to the upper end portion of the main body 35 by allowing the contacting part contacting hole 48 provided in the axial part 30 and the axial part contacting hole 40 provided in the main body 35 to connect each other. More specifically, the hole 50 for charging or discharging a cooling medium provided in one axial part 30 is connected to the hole 50 for charging or discharging a cooling medium provided in the other axial part 30 through the internal flow path 42 of one axial part 30, the internal flow path 37 of one main body 35, the internal flow paths 34 of the pipes 32, the internal flow path 37 of the other main body 35, and the internal flow path 42 of the other axial part 30.

A hook 52 for hoisting the silicon supporting apparatus 14 is attached to the axial part 30. The hook 52 is a substantially rectangular-shaped plate extending in a direction orthogonal to the axial part 30. As shown in Fig. 7, in the center of the hook 52, there is provided a through hole 54 for allowing the axial part 30 to pass through. At the upper and lower positions with respect to the through hole 54 in the hook 52, there are provided wire hooking portions 56 for hooking a wire of the crane 20 to hoist the silicon supporting apparatus 14. The hook 52 is fixed by welding or the like to the axial part 30 at substantially the center in the longitudinal direction of the axial part 30.

As shown in Fig. 1, the heating apparatus 16 is for heating the material silicon 12 supported by the silicon supporting apparatus 14 at atmospheric pressure. Inside the heating apparatus 16, there is provided a heater 58 for heating the material silicon 12 to a predetermined temperature. Further, the heating apparatus 16 has a device (not shown) for opening and closing the heating apparatus 16 when the material silicon 12 and the silicon supporting apparatus 14 are put in and taken out of the heating apparatus 16. The heating apparatus 16 is being closed while the heating apparatus 16 is stopped or the material silicon 12 is heated, but is opened when the material silicon 12 and the silicon supporting apparatus 14 are put in or taken out of the heating apparatus 16.

The water tank 18 is used to reserve water for quenching the material silicon 12, and has a size allowing the silicon supporting apparatus 14 while supporting the material silicon 12 to be submerged into water contained therein. According to the first embodiment of the present invention, ultrapure water is used as water for quenching the material silicon 12.

The crane 20 is for hoisting the silicon supporting apparatus 14 and transfer it from the heating apparatus 16 to the water tank 18, and is also for keeping the silicon supporting apparatus 14 at a predetermined position or height.

A procedure for heating and cooling the material silicon 12 using the equipment 10 for heating and quenching silicon according to the first embodiment of the present invention will be descried with reference to Fig. 8.

The power switch (not shown) of the heating apparatus 16 is turned on to feed power to the heater 58 of the heating apparatus 16 to increase the internal temperature up to about 1,000°C under atmospheric pressure.

A hose 59 is connected to the hole 50 for charging or discharging a cooling medium provided in one axial part 30 of the silicon supporting apparatus 14 and the hole 50 for charging or discharging a cooling medium provided in the other axial part 30 of the silicon supporting apparatus 14, respectively. Then, a cooling medium L is fed to one axial part 30 through the hole 50 for charging or discharging a cooling medium provided in one axial part 30.

The amount of the cooling medium L to be fed is determined so that the temperatures of the contact-preventing member 24, the fixing member 26, and the contact-preventing member 36 for the contacting part can be kept at 380°C or less when the silicon supporting apparatus 14 is heated in the heating apparatus 16. Particularly, according to the first embodiment of the present invention, there is a difference in the temperature of the contact-preventing member 24 between a part around which the fixing member 26 is wound, and a part around which the fixing member 26 is not wound. It is necessary to determine the amount of the cooling medium L to be fed so that the temperature of a part of the contact-preventing member 24 around which the fixing member 26 is not wound can be kept at 380°C or less. More specifically, a part of the contact-preventing member 24 around which the fixing member 26 is wound is contacted to the pipe 32 closely, and therefore benefits greatly from the cooling effect of the cooling medium L flowing inside the pipe 32. On the other hand, a part of the contact-preventing member 24 around which the fixing member 26 is not wound is contacted to the pipe 32 loosely, and benefits less from the cooling effect of the cooling medium L flowing inside the pipe 32.

The cooling medium L fed into the internal flow path 42 of one axial part 30 is discharged from the hole 50 for charging or discharging a cooling medium provided in the other axial part 30 via one main body 35, a plurality of the pipes 32, and the other main body 35.

After it is confirmed that the internal temperature of the heating apparatus 16 has been increased to a predetermined temperature, the heating apparatus 16 is opened by the opening and closing device. Then, the silicon supporting apparatus 14 while supporting the material silicon 12 is placed in the heating apparatus 16 using the crane 20, and then the heating apparatus 16 is closed. Then, the material silicon 12 is heated up to about 600°C in the heating apparatus 16 which has been heated to a predetermined temperature (see Fig. 8(a)).

At this time, the silicon supporting apparatus 14 is also heated, but the temperatures of the pipes 32, the contacting part main bodies 35, and the axial parts 30 constituting the silicon supporting apparatus 14 are not undesirably increased because the cooling medium L flows inside them. Moreover, the contact-preventing member 24 fixed to the pipe 32 in such a manner that they are brought into surface contact to each other and the fixing member 26 also benefit from the cooling effect of the cooling medium L flowing inside the pipe 32, and therefore the temperatures of the contact-preventing member 24 and the fixing member 26 are not undesirably increased, thereby making it possible to avoid the contact-preventing member 24 and the fixing member 26 from becoming brittle. In addition, the contact-preventing member 36 for the contacting part which is in close contact with the main body 35 also benefits from the cooling effect of the cooling medium L flowing inside the main body 35, and therefore the temperature of the contact-preventing member 36 for the contacting part is not undesirably increased, thereby making it possible to avoid the contact-preventing member 36 for the contacting part from becoming brittle.

After the completion of the heating of the material silicon 12, the heating apparatus 16 is opened, and the material silicon 12 and the silicon supporting apparatus 14 are taken out of the heating apparatus 16 and submerged in ultrapure water contained in the water tank 18 immediately (see Fig. 8 (b)). As a result, the material silicon 12 is quenched by ultrapure water contained in the water tank 18 so that cracks are produced in the material silicon 12. The temperatures of the components of the silicon supporting apparatus 14 , such as the pipes 32, which benefit from the cooling effect of the cooling medium L do not become higher than that of the material silicon 12, and therefore cracks or failures are not caused in the silicon supporting apparatus 14 by cooling the silicon supporting apparatus 14 with ultrapure water contained in the water tank 18.

After sufficiently cooled with water contained in the water tank 18, the material silicon 12 is taken out of the water tank 18, and is then placed on a floor to complete heating and quenching of the material silicon 12 by means of the equipment 10 for heating and quenching silicon (see Fig. 8(c)). The material silicon 12 having cracks is very brittle, and therefore can be easily crushed into pieces only by applying slight impact.

In the silicon supporting apparatus 14 according to the first embodiment of the present invention, the contact-preventing member 24 made of titanium is provided between the material silicon 12 and the pipe 32 to prevent the contact between the material silicon 12 and the pipe 32. In addition, since the contact-preventing member 24 is fixed to the pipe 32 by means of the fixing member 26, it is not necessary to coat the pipes 32 with titanium. Therefore, there is no fear that the generation of pinholes resulting from a coating process. Further, the difference in elongation between the pipe 32 and the contact-preventing member 24 and fixing member 26 caused by alternate heating and cooling of the silicon supporting apparatus 14 is mainly absorbed by the expansion and contraction of the fixing member 26, and there is no fear that the contact-preventing member 24 will be fallen off the pipe 32.

In case that abrasion of the contact-preventing member 24 or the fixing member 26 occurs, the silicon supporting apparatus 14 can be repaired by replacing just the damaged contact-preventing member 24 or fixing member 26, and therefore it is not necessary to send the silicon supporting apparatus 14 to a factory for repair.

As described above, according to the first embodiment of the present invention, since there is no fear that the generation of pinholes and the falling off of the contact-preventing member 24 from the pipe 32, foreign substances will NOT be adhered to the surface of the material silicon 12. This makes it possible to provide an easy-maintenance silicon supporting apparatus 14 which can support material silicon 12 without reducing its purity, and equipment 10 for heating and quenching silicon using such the silicon supporting apparatus 14.

Further, since the contact-preventing member 24 is fixed to the pipe 32 by winding the fixing member 26 around the contact-preventing member 24 and the pipe 32, the contact-preventing member 24 is easily detachable. This also makes it possible to provide an easy-maintenance silicon supporting apparatus 14.

Further, since the contact-preventing member 24 is formed by longitudinally dividing a pipe into two or more, the contact-preventing member 24 heated in the heating apparatus 16 tends to spread outward to become flattened. At this time, the fixing member 26 wound around the contact-preventing member 24 is always subjected to the force of the contact-preventing member 24 that tends to spread outward, thereby making it possible to prevent the fixing member 26 from loosening due to vibration or the like.

Further, chemically-stable titanium oxide having a high hardness is usually formed on the surface of titanium, but if titanium is heated to about 380°C or higher, titanium oxide is formed not only on the surface but also inside the contact-preventing member 24 and the fixing member 26 so that the contact-preventing member 24 and the fixing member 26 become brittle. However, in the silicon supporting apparatus 14 according to the first embodiment of the present invention, the pipes 32 and the contact-preventing member 24 and the fixing member 26 which are provided so as to be in contact with the outer surface of the pipes 32 are cooled by the cooling medium L flowing in the internal flow paths 34 of the pipes 32, and the contact-preventing member 36 for the contacting part provided so as to be in close contact with the main body 35 also benefits from the cooling effect of the cooling medium L flowing inside the main body 35, and therefore the surface temperature of the contact-preventing member 36 for the contacting part is not undesirably increased. Therefore, even when the silicon supporting apparatus 14 is heated together with the material silicon 12 in the heating apparatus 16 at 1000°C, the temperatures of the contact-preventing member 24 and the fixing member 26 are not undesirably increased, thereby making it possible to avoid the contact-preventing member 24 and the fixing member 26 from becoming brittle.

Further, since the silicon-supporting part 22 for supporting the material silicon 12 is constituted from a plurality of the pipes 32, the silicon-supporting part 22 can be altered to suit the size or shape of the material silicon 12 by changing the number of the pipes 32 or the spacing between the adjacent pipes 32.

Further, since the contacting part 28 is provided at the end of the silicon-supporting part 22 so that the material silicon 12 may contact to it, in the event that the material silicon 12 moves on the silicon-supporting part 22 in the axial direction of the pipe 32, the material silicon 12 contacts to the contacting part 28 provided at the end of the silicon-supporting part 22 and therefore cannot move beyond the contacting part 28, thereby making it possible to prevent the material silicon 12 from falling off the silicon supporting apparatus 14.

Further, since the titanium-made contact-preventing member 36 for the contacting part is provided between the material silicon 12 and the main body 35 to prevent the contact between the material silicon 12 and the main body 35, there is no fear that the purity of the material silicon 12 will be reduced due to the adhesion of foreign substances to the surface of the material silicon 12.

According to the first embodiment of the present invention, the pipe 32 is made of stainless steel, but the material of the pipe 32 is not limited to stainless steel, and other materials can also be used.

Further, the contact-preventing, member 24 may have a sector-shaped cross section as shown in Fig. 9(a) as long as it is a member made of titanium and provided between the material silicon 12 and the pipe 32 so as to be in contact with the outer surface of the pipe 32 to prevent the contact between the material silicon 12 and the pipe 32. However, in a case where the material silicon 12 has a wedge shape as shown in Fig. 9 (a) or 9 (b) , there is a fear that the tip of the wedge-shaped material silicon 12 will come into contact to the pipe 32. For this reason, the contact-preventing member 24 according to the first embodiment of the present invention having a cross-sectional shape obtained by longitudinally dividing a pipe into equal halves is preferred (see Fig. 9(b)).

Further, the fixing member 26 is not limited to a strip-shaped, and may have other shapes. For example, as shown in Fig. 10, the contact-preventing member 24 and the fixing member 26 may be integrally formed.

Further, according to the first embodiment of the present invention, the material silicon 12 supported by the silicon supporting apparatus 14 is submerged in water contained in the water tank 18 for quenching. However, a method for quenching the material silicon 12 is not limited thereto. For example, the material silicon 12 may be quenched by spraying a low-temperature medium such as liquid nitrogen onto the heated material silicon 12.

### (Second Embodiment)

A second embodiment according to the present invention will be described based on Fig. 11. As described above, in the first embodiment according to the present invention, the contact-preventing member 24 is attached to each of the pipes 32. However, the second embodiment according to the present invention is different from the first embodiment in that one sheet of the contact-preventing member 24 is attached to the silicon-supporting part 22. Therefore, the second embodiment according to the present invention will be described by focusing on the contact-preventing member 24, and as the description of the structures, functions, and effects of other components according to the second embodiment of the present invention, the description thereof according to the first embodiment of the present invention is incorporated herein by reference.

The contact-preventing member 24 according to the second embodiment is a plate (a perforated metal plate) made of titanium, having a plurality of water through holes 60, and curved along a virtual curved surface formed by a plurality of all the pipes 32. Such a contact-preventing member 24 is laid on the upper side (i.e., on the side for supporting the material silicon 12) of the silicon-supporting part 22 constituted from a plurality of the pipes 32, and is then fixed to the pipes 32 by means of the fixing member 26. In addition, as shown in Fig. 12, the contact-preventing member 24 has a plurality of pairs of fixing member through holes 62 for allowing the strip-shaped fixing member 26 to pass through.

A method for fixing the contact-preventing member 24 by means of the fixing member 26 will be specifically described with reference to Fig. 12. First, a plurality of the pipes 32, the contact-preventing member 24, and the fixing member 26 are prepared (see Fig. 12(a)). Then, the contact-preventing member 24 is laid on a plurality of the pipes 32, and then one end 26a and the other end 26b of the fixing member 26 are passed through the fixing member through holes 62 provided in the contact-preventing member 24 from the upper side of the silicon-supporting part 22 so that the fixing member 26 contacts to the outer surface of the contact-preventing member 24 (see Fig. 12(b)).

Then, the fixing member 26 is wound around the pipe 32 to fix the contact-preventing member 24 to the pipe 32. At this time, since the fixing member 26 has a length slightly larger than the outer circumferential length of the pipe 32, one end 26a of the fixing member 26 and the other end 26b of the fixing member 26 overlap each other. Therefore, one end 26a of the fixing member 26 is folded back and then the other end 26b of the fixing member 26 is inserted between the folds (see Fig. 12(c)). Then, both the ends 26a and 26b of the fixing member 26 are together folded toward the outer surface of the pipe 32. In this way, the contact-preventing member 24 is fixed to the pipe 32 by means of the fixing member 26 (see Fig. 12(d)).

According to the second embodiment of the present invention, since the contact-preventing member 24 is laid on a plurality of the pipes 32, it is possible to more easily detach the contact-preventing member 24 attached to the entire silicon-supporting part 22 as compared to a case where the contact-preventing member 24 is attached to each of the pipes 32. This makes it possible to provide an easy-maintenance silicon supporting apparatus 14.

Further, at the time when the silicon supporting apparatus 14 while supporting the material silicon 12 is submerged in water contained in the water tank 18 to quench the material silicon 12 and then the material silicon 12 is taken out of the water, the water can pass through the water through holes 60 provided in the contact-preventing member 24, and therefore the silicon supporting apparatus 14 is easily submerged in water contained in the water tank 18 and is well drained when taken out of the water.

The contact-preventing member 24 according to the second embodiment of the present invention has water through holes 60 over the entire surface thereof, but the arrangement of the water through holes 60 is not limited thereto as long as the silicon supporting apparatus 14 can be easily submerged in water and can be well drained when taken out of the water. For example, the water through holes 60 may be provided only in an area corresponding to the space between the adjacent pipes 32. In this case, the water through holes 60 are not present in areas corresponding to the pipes 32, and it is possible to minimize the possibility that the material silicon 12 will be brought into contact with the pipes 32 against the contact-preventing member 24 formed by longitudinally dividing a pipe into equal halves.

The size of the water through hole 60 is made smaller than that of the material silicon 12 (e.g., diameter: 300 mm, length: 1,000 mm) to prevent the material silicon 12 from falling off the silicon supporting apparatus 14 , and it is preferred that the size of the water through hole 60 is smaller than that of a crushed piece of the material silicon 12 (e.g., about 15 mm square). When small pieces of silicon are separated from the material silicon 12 when the heated material silicon 12 is submerged in water contained in the water tank 18, it is possible to prevent the small pieces of silicon from falling off the silicon supporting apparatus 14.

The shape of the contact-preventing member 24 is not limited to a curved plate shape, and may be a corrugated plate shape.

Further, the contact-preventing member 24 is not limited to a perforated metal plate used in the second embodiment of the present invention, and may be, for example, a mesh formed from titanium wires. In this case, the mesh size of the mesh needs to be made smaller than the size of the material silicon 12 supported by the silicon-supporting part 22.

According to the second embodiment of the present invention, the contact-preventing member 24 has a size allowing the entire surface of the silicon-supporting part 22 to be covered with it. However, the size of the contact-preventing member 24 is not limited thereto as long as it is possible to prevent the contact between the material silicon 12 and the pipes 32. For example, the contact-preventing member 24 may have a smaller size to cover only a part of the silicon-supporting part 22 needed to be covered with it.

## Claims

1. An apparatus (14) for supporting material silicon (12) while it is heated and quenched, the apparatus comprising:
a silicon-supporting part (22) for supporting the material silicon (12), having a plurality of pipes (32) arranged to be spaced apart from each other at predetermined intervals and each having an internal flow path (34) for flowing a cooling medium L;
at least one contact-preventing member (24) made of titanium and provided to be contacted with an outer surface of the pipe (32) to prevent the contact between the material silicon (12) and the pipe (32); and
a fixing member (26) made of titanium and fixing the contact-preventing member (24) to the pipe (32).

2. The apparatus according to claim 1, wherein the contact-preventing member (24) is formed by longitudinally dividing a titanium-made pipe into two or more; the fixing member (26) has a strip shape; and
the contact-preventing member (24) is fixed to the pipe (32) by winding the fixing member 26 around the contact-preventing member (24) and the pipe (32) together.

3. The apparatus according to claim 1, wherein the contact-preventing member (24) having at least one water through hole (60) is laid on a plurality of the pipes (32).

4. The apparatus according to any one of claims 1 to 3, further comprising:
a contacting part (28) provided at the end of the silicon-supporting part (22) and contacting the material silicon (12); wherein the contacting part (28) has a main body (35) and a titanium-made contact-preventing member (36) for the contacting part provided between the material silicon (12) and the main body (35) to prevent from contacting between the material silicon (12) and the main body (35).

5. Silicon heating and quenching equipment, the equipment comprising:
the silicon supporting apparatus according to any one of claims 1 to 4;
a heating apparatus (16) for heating the material silicon (12) and the silicon supporting apparatus (14);
a water tank (18) with water for submerging the material silicon (12) and the silicon supporting apparatus (14) to quench.

## Patentansprüche

1. Vorrichtung (14) zum Lagern von Silizium-Material (12), während dieses erhitzt und dann abgekühlt wird, wobei die Vorrichtung Folgendes aufweist:
einen Silizium-Lagerabschnitt (22) zum Lagern des Silizium-Materials (12), mit einer Mehrzahl von Röhren (32), die mit vorbestimmten Abständen voneinander beabstandet angeordnet sind und jeweils einen inneren Flusskanal (34) zum Durchfluss eines Kühlmediums L aufweisen;
mindestens ein Kontaktverhinderungselement (24) aus Titan, welches vorgesehen ist, um mit einer äußeren Oberfläche der Röhre (32) in Kontakt zu kommen und um Kontakt zwischen dem Silizium-Material (12) und der Röhre (32) zu verhindern; und
ein Befestigungselement (26) aus Titan, welches das Kontaktverhinderungselement (24) an der Röhre befestigt.

2. Vorrichtung (14) gemäß Anspruch 1, wobei das Kontaktverhinderungselement (24) durch Teilen einer Röhre aus Titan in Längsrichtung in zwei oder mehr Stücke gebildet ist;
das Befestigungselement (26) streifenförmig ist; und
das Kontaktverhinderungselement (24) an der Röhre (32) befestigt ist, indem des Kontaktverhinderungselements (24) zusammen mit der Röhre (32) mit dem Befestigungselement (26) umwickelt wird.

3. Vorrichtung (14) gemäß Anspruch 1, wobei das Kontaktverhinderungselement (24) mindestens ein Wasserdurchflussloch (60) aufweist und über einer Mehrzahl der Röhren (32) gelegt ist.

4. Vorrichtung (14) gemäß einem der Ansprüche 1 bis 3, weiterhin aufweisend:
einen Kontaktabschnitt (28), der am Ende des Silizium-Lagerabschnitts (22) vorgesehen ist und das Silizium-Material (12) konaktiert; wobei der Kontaktabschnitt (28) einen Hauptteil (35) und ein Kontaktverhinderungselement (36) aus Titan für den Kontaktabschnitt zwischen dem Silizium-Material (12) und dem Hauptteil (35) aufweist, um Kontakt zwischen dem Silizium-Material (12) und dem Hauptteil (35) zu verhindern.

5. Anlage zum Erhitzen und Abkühlen von Silizium, aufweisend:
die Vorrichtung zum Lagern von Silizium gemäß einem der Abschnitte 1 bis 4;
eine Erhitzungsvorrichtung (16) zum Erhitzen des Silizium-Materials (12) und der Vorrichtung (14) zum Lagern von Silizium;
einen Wassertank (18) mit Wasser zum Eintauchen des Silizium-Materials (12) und der Vorrichtung (14) zum Lagern von Silizium, um diese abzukühlen.

## Revendications

1. Appareil (14) destiné à porter du silicium (12) lorsqu'il est chauffé et trempé, ledit appareil comportant :
- une partie porteuse de silicium (22) destinée à porter le silicium (12), munie d'un grand nombre de tubes (32) disposés les uns à distance des autres à des intervalles prédéfinis, chacun d'eux ayant un canal intérieur (34) destiné à conduire un agent de refroidissement L,
- au moins un élément empêchant le contact (24) en titane qui est en contact avec une surface extérieure du tube (32) pour empêcher le contact entre le silicium (12) et le tube (32), et
- un élément de fixation (26) en titane qui fixe l'élément empêchant le contact (24) au tube (32).

2. Appareil selon la revendication 1, dans lequel l'élément empêchant le contact (24) est formé en divisant en sens longitudinal, en deux parties ou plus, un tube en titane, l'élément de fixation (26) a une forme de bande et l'élément empêchant le contact (24) est fixé au tube (32) en enroulant l'élément de fixation (26) à la fois autour de l'élément empêchant le contact (24) et du tube (32).

3. Appareil selon la revendication 1, dans lequel l'élément empêchant le contact (24) muni d'au moins un orifice d'écoulement d'eau (60) s'étend sur un grand nombre de tubes (32).

4. Appareil selon l'une des revendications 1 à 3, comportant en outre une partie de contact (28) qui est prévue à l'extrémité de la partie porteuse de silicium (22) et assure le contact avec le silicium (12), la partie de contact (28) ayant un corps principal (35) et un élément empêchant le contact (36) en titane pour la partie de contact prévue entre le silicium (12) et le corps principal (35) afin d'empêcher le contact entre le silicium (12) et le corps principal (35).

5. Installation pour chauffer et tremper le silicium, ladite installation comportant :
- l'appareil porteur de silicium selon l'une des revendications 1 à 4,
- un appareil de chauffage (16) pour chauffer le silicium (12) et l'appareil porteur de silicium (14),
- un réservoir d'eau (18) rempli d'eau pour immerger le silicium (12) et l'appareil porteur de silicium (14) pour assurer la trempe.
